# EUROPEAN PATENT SPECIFICATION

(11) **EP 3 301 377 B1**
(45) Date of publication and mention of the grant of the patent: **30.10.2019**
(21) Application number: 17194046.3
(22) Date of filing: 29.09.2017
(51) Int. Cl.: F24F 11/64, F24F 11/67, H01M 10/613, F24F 110/10

(54) **METHODS OF SPACE COOLING**
VERFAHREN ZUR RAUMKÜHLUNG
PROCÉDÉS DE REFROIDISSEMENT DE L'ESPACE

(30) Priority: 03.10.2016 GB 201616749
(43) Date of publication of application: 04.04.2018
(73) Proprietor: GE Energy Power Conversion Technology Ltd, Rugby Warwickshire CV21 1BU (GB)
(72) Inventor: INGLES, Martin Richard, Rugby, Warwickshire CV21 1BU (GB); MULLEY, Simon, Rugby, Warwickshire CV21 1BU (GB)
(74) Representative: Serjeants LLP

(56) References cited:
- EP-A1- 2 830 146
- WO-A1-2017/002591
- JP-A- 2002 027 612
- US-A1- 2007 298 316
- US-A1- 2014 308 545

## Description

### TECHNICAL FIELD

The present invention relates to a method of cooling a space using a cooling system, and in particular to a space in which an energy storage device is located. The method provides improved cooling directly in response to the charging or discharging operation of the energy storage device. A method according to the preamble of claim 1 and an apparatus according to the preamble of claim 4 is shown in document EP 2 830 146.

### SUMMARY OF THE INVENTION

The present invention provides a method of cooling a space as defined in claim 1.

The cooling system is controlled with reference to a cooling temperature setpoint such that cooling is provided when a measured temperature within the space is equal to, or higher than, the cooling temperature setpoint and cooling is not provided when a measured temperature within the space is lower than the cooling temperature setpoint. In such an arrangement, the cooling system can be controlled by decreasing the cooling temperature setpoint directly in response to the energy storage device being charged or discharged.

The temperature within the space can be measured by one or more sensors which provide temperature signals to the cooling system. The measured temperature is compared against the cooling temperature setpoint, e.g., by a control unit which is used to control the operation of the cooling system.

When the energy storage device is not being charged or discharged, the cooling temperature setpoint can be set to a default value (e.g., 20°C) so that the cooling system provides the desired level of space cooling based on conventional thermostat control. The default value can be set by the control unit. The default value can take account of environmental and application-specific parameters such as the external ambient temperature outside the space, the size and configuration of the space, the ideal storage temperature of the energy storage device etc. and can be fixed or variable. If the default value is variable, the cooling system is normally controlled using a time-dependent cooling temperature setpoint profile and any reference herein to a default value will refer to the prevailing default value at the time when the energy storage device charging or discharging starts or ends.

When the energy storage device starts being charged or discharged, the control unit decreases the cooling temperature setpoint from the default value to a modified value that is typically used for the duration of the charging or discharging operation. In other words, the modified value is lower than the default value.

The cooling temperature setpoint can be decreased by a predetermined amount immediately (i.e., as a stepwise change) or over a period of time (i.e., as a ramped change). For example, if the default value of the cooling temperature setpoint is set to 20°C, the modified value of the cooling temperature setpoint can be 15°C so that the cooling temperature setpoint is decreased by 5°C as soon as the energy storage device starts being charged or discharged. The cooling system will be controlled to provide space cooling if the measured temperature within the space is equal to, or greater than, the modified value of 15°C while the energy storage device is being charged or discharged.

The energy storage device will typically generate more heat when it is being charged or discharged at a high level than it does when it is being charged or discharged at moderate level or low level. The cooling temperature setpoint can also be decreased by an amount that is determined with reference to the level of charging or discharging of the energy storage device. For example, if the default value of the cooling temperature setpoint is 20°C, the modified value of the cooling temperature setpoint can be 17.5°C for a low charging or discharging level, 15°C for a moderate charging or discharging level, or 10°C for a high charging or discharging level. It will be readily understood that these modified values are just examples and that a more complex relationship between the charging or discharging level and the modified value of the cooling temperature setpoint could be used in practice, e.g., by means of a suitable look-up table or equation. In general terms, the modified value of the cooling temperature setpoint can be a predetermined modified value or determined with reference to the level of charging or discharging of the energy storage device.

After an initial decrease in the cooling temperature setpoint, the cooling temperature setpoint can remain at the modified value or it can be varied, e.g., with reference to the level of charging or discharging of the energy storage device while it is being operated. The method can further comprise the step of increasing the cooling temperature setpoint to the default value (e.g., 20°C) when the energy storage device is no longer being charged or discharged. The cooling system will continue to provide space cooling if a measured temperature within the space is equal to, or greater than, the default value. If the measured temperature within the space is less than the default value of the cooling temperature setpoint, space cooling will be stopped.

In the arrangement described above, no direct control of the cooling system is needed - the control functions of the cooling system remain unaltered because it is only the cooling temperature setpoint that is changed in response to the energy storage device charging or discharging. If the energy storage device includes a control unit, the control unit can send a command signal to the cooling system to decrease the cooling temperature setpoint (e.g., to switch from a default value to a lower modified value) when the energy storage device starts being charged or discharged. In one arrangement, the energy storage device can be connected to a power converter, e.g., a DC/AC or DC/DC converter that is used to interface the energy storage device to an electric circuit or network. The power converter can include a control unit. The control unit can send a command signal to the cooling system to decrease the cooling temperature setpoint when the energy storage device starts being charged or discharged.

In an alternative arrangement, which does not fall within the scope of the claims, the step of controlling the operation of the cooling system can comprise increasing the power mode of the cooling system so that it provides increased space cooling. (This step can also comprise starting space cooling if the cooling system was not previously operating because the measured temperature was below the default value of the cooling temperature setpoint.) The term "power mode" is intended to refer generally to the operating parameters of the cooling system that control the level of space cooling provided by the cooling system. Such parameters will depend on the type of cooling system that is used but may include inter alia operating parameters of a heat pump or refrigeration or air conditioning equipment (e.g., compressor, pump etc.), operating speed of air movers such as fans or blowers, for example. The power mode of the cooling system can be increased immediately (i.e., as a stepwise change) or over a period of time (i.e., as a ramped change). A control unit (e.g., for the energy storage device or optional power converter - see above) can send a command signal to the cooling system to control its operation directly in response to the energy storage device being charged or discharged. Any conventional thermostat control can be overridden or temporarily disabled. For example, the cooling system can be controlled to operate in a maximum power mode, or at a percentage of its maximum power mode that can optionally be determined with reference to the level of charging or discharging of the energy storage device. In an arrangement where the cooling system is an HVAC system, operating the cooling system at a maximum power mode might involve operating the air conditioning equipment at a maximum level and operating air movers at a maximum speed. The power mode can be fixed for the duration of the charging or discharging operation or varied, e.g., with reference to the level of charging or discharging of the energy storage device. The method can further comprise the step of operating the cooling system in its normal power mode (i.e., with conventional thermostat control) when the energy storage device is no longer being charged or discharged, or after a predetermined period of time has elapsed.

Space heating can be provided by a heating system. In one arrangement, the heating system can be an electrical resistance heating system that would typically be located within the space and use conventional thermostat control to keep the temperature above a heating temperature setpoint. More particularly, the heating system can be controlled with reference to a heating temperature setpoint such that heating is provided when a measured temperature within the space is equal to, or lower than, the heating temperature setpoint and heating is not provided when a measured temperature within the space is higher than the heating temperature setpoint. The heating system can be turned off, temporarily disabled or otherwise controlled in response to the energy storage device being charged or discharged. For example, a command signal can be sent by a control unit to turn off the heating system when the energy storage device is being charged or discharged and to turn on the heating system when the energy storage device is no longer being charged or discharged.

It will be readily understood that the energy storage device will generate heat when it is charging or discharging. In a conventional arrangement that relies solely on thermostat control, the heat generated by the energy storage device would increase the temperature within the space and the cooling system would eventually start to provide space cooling when the measured temperature reaches the cooling temperature setpoint. However, there is often a significant time lag between heat starting to be generated by the charging or discharging operation of the energy storage device and space cooling being provided by the cooling system. This is the case even if one or more temperature sensors are positioned physically adjacent the energy storage device, e.g., on the storage rack. In the case of the present invention, space cooling can be provided as soon as the energy storage device starts being charged or discharged and before any increase in the temperature within the space is measured by the temperature sensors. This is achieved by decreasing the cooling temperature setpoint (typically to a modified value that is sufficient to start space cooling, and in particular to place the cooling system into a high power mode or setting) or by directly controlling the operation of the cooling system to increase its power mode. Consequently, space cooling is controlled on the basis of the operational status of the energy storage device (i.e., when charging or discharging is demanded) and not simply on conventional thermostat control. Improving the cooling of the energy storage device to maintain it within its ideal storage temperature can prolong device lifetime and increase operational efficiency.

The present invention further provides an apparatus according to claim 4.

The cooling system is controlled with reference to a cooling temperature setpoint such that cooling is provided when a measured temperature within the space is equal to, or higher than, the cooling temperature setpoint and cooling is not provided when a measured temperature within the space is less than the cooling temperature setpoint. The measured temperature can be provided by one or more sensors which provide temperature signals to the cooling system.

The control unit can be adapted to decrease the cooling temperature setpoint in response to the energy storage device being charged or discharged. The control unit can be further adapted to increase the cooling temperature setpoint to a default value when the energy storage device is no longer being charged or discharged.

The control unit can be associated with the energy storage device and sends a command signal to the cooling system to decrease the cooling temperature setpoint when the energy storage device starts being charged or discharged. According to the invention, the apparatus comprises a power converter connected to the energy storage device. The control unit is associated with the power converter and sends a command signal to the cooling system to decrease the cooling temperature setpoint when the energy storage device starts being charged or discharged.

In an alternative arrangement, which does not fall within the scope of the claims, the step of controlling the operation of the cooling system can comprise increasing the power mode of the cooling system so that it provides increased space cooling. The control unit (e.g., for the energy storage device or optional power converter - see above) can send a command signal to the cooling system to control its operation directly in response to the energy storage device being charged or discharged. For example, the cooling system can be controlled to operate in a maximum power mode, or at a percentage of its maximum power that can optionally be determined with reference to the level of charging or discharging of the energy storage device. The power mode can be fixed for the duration of the charging or discharging operation or varied, e.g., with reference to the level of charging or discharging of the energy storage device.

### DRAWINGS

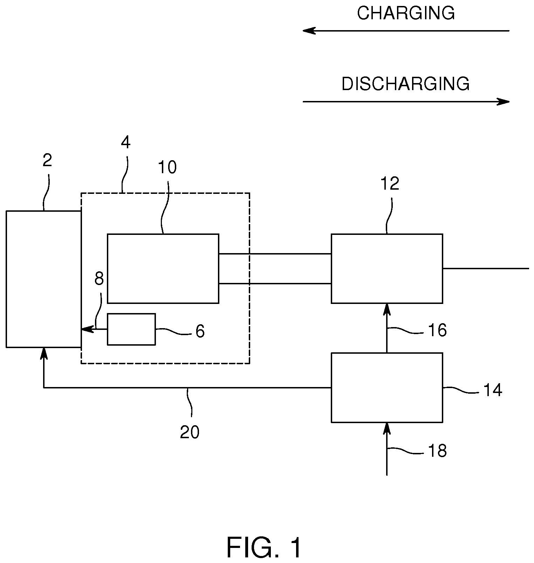

Figure 1 is a schematic drawing of an apparatus according to the present invention.

With reference to Figure 1, a heating, ventilation and air conditioning (HVAC) system 2 is used to cool a battery room 4. One or more temperature sensors 6 are positioned within the battery room 4 and provide temperature measurements 8 to the HVAC system 2. The HVAC system 2 is operated using thermostat control. In particular, the HVAC system 2 uses a cooling temperature setpoint that in one example is set to a default value of 20°C. The HVAC system 2 provides space cooling by delivering cooled air into the battery room 4 if the measured temperature within the battery room is equal to, or higher than, the default value. The HVAC system 2 does not deliver cooled air into the battery room 4 if the measured temperature within the battery room is below the default value.

A battery 10 is positioned within the battery room 4. The battery 10 provides a DC output and is connected to a DC/AC power converter 12. The operation of the power converter 12 is controlled by a control unit 14. The control unit 14 sends command signals 16 to the power converter 12, e.g., to control the on/off operation of semiconductor switching devices within the power converter. The control unit 14 receives command signals 18 from a higher level control unit (not shown) which provides overall control for the charging and/or discharging of the battery 10. The control unit 14 also sends command signals 20 to the HVAC system 2.

When the control unit 14 receives command signals 18 from the higher level control unit (not shown) to start operating the power converter 12 to charge the battery 10 (i.e., to supply power from an AC circuit to the battery 10) or to discharge the battery (i.e., to supply power from the battery to the AC circuit), the control unit 14 sends command signals 16 to the power converter 12 and command signals 20 to the HVAC system 2.

When the HVAC system 2 receives the command signals 20 from the control unit 14, the cooling temperature setpoint is switched to a modified value of 15°C. If it is assumed that the measured temperature within the battery room 4 was 18°C immediately prior to the command signals 20 being received by the HVAC system 2, it will be readily understood that the HVAC system 2 was not delivering cooled air into the battery room because the measured temperature was below the default value of 20°C. However, the measured temperature of 18°C is now higher than the modified value of 15°C so the HVAC system 2 is operated on the basis of the normal thermostat control to start to deliver cooled air into the battery space 4 to provide space cooling. Space cooling is therefore started directly in response to the battery 10 being charged or discharged and before any heat generated by the battery raises the measured temperature above the default value of 20°C. In another arrangement, the command signals sent by the control unit can be used to control the HVAC system to start operating in a maximum power mode to deliver cooled air into the battery room.

When the control unit 14 receives command signals 18 from the higher level control unit (not shown) to stop operating the power converter 12, the control unit 14 sends command signals 16 to the power converter 12 and command signals 20 to the HVAC system 2.

When the HVAC system 2 receives the command signals 20 from the control unit 14, the cooling temperature setpoint is switched back to the default value of 20°C. If it is assumed that the measured temperature within the battery room 4 was 18°C immediately prior to the command signals 20 being received by the HVAC system 2, it will be readily understood that the HVAC system 2 will stop delivering cooled air into the battery room 4 because the measured temperature is below the default value of 20°C. However, if the heat generated by the battery 10 means that the measured temperature was 22°C immediately prior to the command signals 20 being received by the HVAC system 2, the HVAC system will continue to deliver cooled air into the battery room 4 until the measured temperature falls below the default value of 20°C. In another arrangement, where the command signals sent by the control unit are used to control the HVAC system to start operating in a maximum power mode when the battery is being charged or discharged, the HVAC system can be switched back to a normal power mode when the charging or discharged operation ends.

## Claims

1. A method of cooling a space (4) using a cooling system (2), wherein an energy storage device (10) is located within the space (4) and is connected to a power converter (12) that includes a control unit (14), the method comprising the step of:
controlling the operation of the cooling system (2) directly in response to the energy storage device (10) being charged or discharged;
wherein the cooling system (2) is controlled with reference to a cooling temperature setpoint such that cooling is provided when a measured temperature within the space (4) is equal to, or higher than, the cooling temperature setpoint and cooling is not provided when a measured temperature within the space (4) is less than the cooling temperature setpoint;
**characterised in that** the control unit (14) sends a command signal (16) to the cooling system (2) to decrease the cooling temperature setpoint when the energy storage device (10) is charged or discharged through the power converter (12).

2. A method according to claim 1, wherein cooling temperature setpoint is reduced to a modified value that is a predetermined modified value or is determined with reference to the level of charging or discharging of the energy storage device (10).

3. A method according to claim 1 or 2, further comprising the step of increasing the cooling temperature setpoint to a default value when the energy storage device (10) is no longer being charged or discharged.

4. Apparatus comprising:
an energy storage device (10) located within a space (4);
a cooling system (2) for cooling the space (4); and
a control unit (14) adapted to control the operation of the cooling system (2) directly in response to the energy storage device (10) being charged or discharged;
wherein the cooling system (2) is controlled with reference to a cooling temperature setpoint such that cooling is provided when a measured temperature within the space (4) is equal to, or higher than, the cooling temperature setpoint and cooling is not provided when a measured temperature within the space (4) is less than the cooling temperature setpoint, the measured temperature being provided by one or more sensors (6) which provide temperature signals to the cooling system (2);
**characterised in that** the apparatus further comprises a power converter (12) connected to the energy storage device (10), wherein the control unit (14) is associated with the power converter (12) and is adapted to send a command signal (20) to the cooling system (2) to decrease the cooling temperature setpoint when the energy storage device (10) starts being charged or discharged.

5. Apparatus according to claim 4, wherein the cooling temperature setpoint is reduced to a modified value and wherein the modified value is a predetermined modified value or is determined with reference to the level of charging or discharging of the energy storage device (10).

6. Apparatus according to claim 4 or 5, wherein the control unit (14) is further adapted to increase the cooling temperature setpoint to a default value when the energy storage device (10) is no longer being charged or discharged.

## Patentansprüche

1. Verfahren zum Kühlen eines Raums (4) unter Verwendung eines Kühlsystems (2), wobei sich eine Energiespeichervorrichtung (10) innerhalb des Raums (4) befindet und mit einem Stromrichter (12) verbunden ist, der eine Steuereinheit (14) enthält, wobei das Verfahren den Schritt aufweist:
Steuern des Betriebs des Kühlsystems (2) direkt als Reaktion darauf, dass die Energiespeichervorrichtung (10) geladen oder entladen wird;
wobei das Kühlsystem (2) in Bezug auf einen Kühltemperatursollwert derart gesteuert wird, dass eine Kühlung bereitgestellt wird, wenn eine gemessene Temperatur innerhalb des Raums (4) gleich dem oder höher als der Kühltemperatursollwert ist, und eine Kühlung nicht bereitgestellt wird, wenn eine gemessene Temperatur innerhalb des Raums (4) kleiner als der Kühltemperatursollwert ist;
**dadurch gekennzeichnet, dass** die Steuereinheit (14) ein Befehlssignal (16) zu dem Kühlsystem (2) sendet, um den Kühltemperatursollwert zu verringern, wenn die Energiespeichervorrichtung (10) über den Stromrichter (12) geladen oder entladen wird.

2. Verfahren nach Anspruch 1, wobei der Kühltemperatursollwert auf einen modifizierten Wert reduziert wird, der ein vorbestimmter modifizierter Wert ist, oder unter Bezugnahme auf das Lade- oder Entladeniveau der Energiespeichervorrichtung (10) bestimmt wird.

3. Verfahren nach Anspruch 1 oder 2, das ferner den Schritt des Erhöhens des Kühltemperatursollwertes auf einen Vorgabewert aufweist, wenn die Energiespeichervorrichtung (10) nicht mehr geladen oder entladen wird.

4. Vorrichtung, die aufweist:
eine Energiespeichervorrichtung (10), die sich innerhalb eines Raums (4) befindet;
ein Kühlsystem (2) zur Kühlung des Raumes (4); und
eine Steuereinheit (14), die eingerichtet ist, um den Betrieb des Kühlsystems (2) direkt als Reaktion darauf zu steuern, dass die Energiespeichervorrichtung (10) geladen oder entladen wird;
wobei das Kühlsystem (2) in Bezug auf einen Kühltemperatursollwert derart gesteuert wird, dass eine Kühlung bereitgestellt wird, wenn eine gemessene Temperatur innerhalb des Raums (4) gleich dem oder höher als der Kühltemperatursollwert ist, und eine Kühlung nicht bereitgestellt wird, wenn eine gemessene Temperatur innerhalb des Raums (4) kleiner als der Kühltemperatursollwert ist, wobei die gemessene Temperatur durch einen oder mehrere Sensoren (6) bereitgestellt wird, die Temperatursignale für das Kühlsystem (2) bereitstellen;
**dadurch gekennzeichnet, dass** die Vorrichtung ferner einen Stromrichter (12) aufweist, der mit der Energiespeichervorrichtung (10) verbunden ist, wobei die Steuereinheit (14) dem Stromrichter (12) zugeordnet ist und eingerichtet ist, um einen Befehlssignal (12) zu dem Kühlsystem (2) zu senden, um den Kühltemperatursollwert zu verringern, wenn die Energiespeichervorrichtung (10) beginnt, geladen oder entladen zu werden.

5. Vorrichtung nach Anspruch 4, wobei der Kühltemperatursollwert auf einen modifizierten Wert reduziert wird und wobei der modifizierte Wert ein vorbestimmter modifizierter Wert ist oder unter Bezugnahme auf das Lade- oder Entladeniveau der Energiespeichervorrichtung (10) bestimmt wird.

6. Vorrichtung nach Anspruch 4 oder 5, wobei die Steuereinheit (14) ferner eingerichtet ist, um den Kühltemperatursollwert auf einen Vorgabewert zu erhöhen, wenn die Energiespeichervorrichtung (10) nicht mehr geladen oder entladen wird.

## Revendications

1. Procédé de refroidissement d'un espace (4) utilisant un système de refroidissement (2), dans lequel un dispositif de stockage d'énergie (10) est placé dans l'espace (4) et est connecté à un convertisseur électrique (12) qui comporte une unité de commande (14), le procédé comprenant l'étape suivante :
commander le fonctionnement du système de refroidissement (2) directement en réponse au dispositif de stockage d'énergie (10) subissant une charge ou une décharge ;
dans lequel le système de refroidissement (2) est commandé en référence à un point de consigne de température de refroidissement, de sorte que le refroidissement est fourni quand une température mesurée dans l'espace (4) est supérieure ou égale au point de consigne de température de refroidissement et que le refroidissement n'est pas fourni quand une température mesurée dans l'espace (4) est inférieure au point de consigne de température de refroidissement ;
**caractérisé en ce que** l'unité de commande (14) envoie un signal de commande (16) au système de refroidissement (2) pour réduire le point de consigne de température de refroidissement quand le dispositif de stockage d'énergie (10) est chargé ou déchargé à travers le convertisseur électrique (12).

2. Procédé selon la revendication 1, dans lequel on réduit le point de consigne de température de refroidissement à une valeur modifiée qui est une valeur modifiée prédéterminée ou qui est déterminée en référence au niveau de charge ou de décharge du dispositif de stockage d'énergie (10).

3. Procédé selon la revendication 1 ou 2, comprenant en outre l'étape consistant à augmenter le point de consigne de température de refroidissement à une valeur par défaut quand le dispositif de stockage d'énergie (10) ne subit plus de charge ou de décharge.

4. Dispositif comprenant :
un dispositif de stockage d'énergie (10) placé dans un espace (4) ;
un système de refroidissement (2) pour refroidir l'espace (4) ; et
une unité de commande (14) adaptée pour commander le fonctionnement du système de refroidissement (2) directement en réponse au dispositif de stockage d'énergie (10) subissant une charge ou une décharge ;
dans lequel le système de refroidissement (2) est commandé en référence à un point de consigne de température de refroidissement, de sorte que le refroidissement est fourni quand une température mesurée dans l'espace (4) est supérieure ou égale au point de consigne de température de refroidissement et que le refroidissement n'est pas fourni quand une température mesurée dans l'espace (4) est inférieure au point de consigne de température de refroidissement, la température mesurée étant fournie par un ou plusieurs capteurs (6) qui fournissent des signaux de température au système de refroidissement (2) ;
**caractérisé en ce que** le dispositif comprend en outre un convertisseur électrique (12) connecté au dispositif de stockage d'énergie (10), dans lequel l'unité de commande (14) est associée au convertisseur électrique (12) et est adaptée pour envoyer un signal de commande (20) au système de refroidissement (2) pour réduire le point de consigne de température de refroidissement quand la charge ou la décharge du dispositif de stockage d'énergie (10) commence.

5. Dispositif selon la revendication 4, dans lequel on réduit le point de consigne de température de refroidissement à une valeur modifiée et dans lequel la valeur modifiée est une valeur modifiée prédéterminée ou est déterminée en référence au niveau de charge ou de décharge du dispositif de stockage d'énergie (10).

6. Dispositif selon la revendication 4 ou 5, dans lequel l'unité de commande (14) est en outre adaptée pour augmenter le point de consigne de température de refroidissement à une valeur par défaut quand le dispositif de stockage d'énergie (10) ne subit plus de charge ou de décharge.
